# DEMANDE DE BREVET EUROPEEN

(11) **EP 4 730 578 A1**
(43) Date de publication de la demande: **22.04.2026**
(21) Numéro de dépôt: 25209814.0
(22) Date de dépôt: 20.10.2025
(51) Int. Cl.: H02B 1/056, H02B 1/56, H01H 9/54

(54) **ENSEMBLE DE DISTRIBUTION ET TABLEAU ÉLECTRIQUE ASSOCIÉ**

(30) Priorité: 21.10.2024 FR 2411464
(71) Demandeur: SCHNEIDER ELECTRIC INDUSTRIES SAS, 92500 Rueil-Malmaison (FR)
(72) Inventeur: DOMEJEAN, Eric, 92500 Rueil-Malmaison (FR); BURNOT, Claude, 92500 Rueil-Malmaison (FR); KILINDJIAN, Christophe, 92500 Rueil-Malmaison (FR)
(74) Mandataire: Lavoix

(57) **Abrégé**

Cet ensemble de distribution (100), configuré pour distribuer de l'énergie électrique provenant d'une source de puissance à au moins une charge électrique, comprend un bus de puissance (124) avec plusieurs barres conductrices (122) présentant chacune, à une extrémité, une portion de connexion à une borne de sortie d'un boitier principal (200). Le bus de puissance définit une zone de connexion, qui s'étend selon un plan de connexion (P124) et qui est prévue pour la connexion d'au moins un boitier de départ (300) d'un côté avant du plan de connexion (P124). L'ensemble de distribution (100) comprend un dispositif de refroidissement (400), qui inclut une plaque de contact (410) pour coopérer avec une face arrière (231) du boitier principal (200), un radiateur (420) qui s'étend d'un côté arrière du plan de connexion (P124), et au moins un caloduc (430), qui relie la plaque de contact (410) au radiateur (420).

## Description

La présente invention concerne un ensemble de distribution de puissance électrique, ainsi qu'un tableau électrique comprenant un tel ensemble de distribution.

L'ensemble de distribution considéré ici permet de relier une source de puissance électrique à au moins une charge électrique. On connait les dispositifs de distribution comprenant des moyens de coupure dits « statiques », c'est-à-dire en particulier des moyens de coupure à semi-conducteurs, qui permettent une coupure rapide sans arcs. Or ces moyens de coupure statiques sont relativement onéreux.

On connait, notamment de GB-2 182 812-A, de connecter des moyens de coupure statiques à plusieurs borniers de départ, chaque bornier de départ étant respectivement associé à des moyens de coupure mécaniques.

Or les moyens de coupure statiques tendent à générer une chaleur importante, notamment lorsque leur fonction de coupure est mise en œuvre, ce qui peut gêner le bon fonctionnement de l'ensemble de distribution, notamment lorsque plusieurs déclenchements se succèdent de manière rapprochée. Il est connu de favoriser les échanges au moyen d'une ventilation, voire d'une climatisation, cependant ces solutions sont bruyantes, consommatrices d'énergie et présentent une fiabilité réduite. Il est aussi connu d'utiliser des dispositifs de refroidissement passifs. US-10 141 722-B2 décrit, par exemple, un dispositif de transfert thermique monté sur les bornes de connexion d'un dispositif de distribution modulaire. CN-205 646 540-U décrit, quant à lui, un dispositif de refroidissement pour une armoire électrique.

C'est à ces problèmes qu'entend plus particulièrement remédier l'invention, en proposant un ensemble de distribution offrant un refroidissement amélioré tout en restant relativement compact.

À cet effet, l'invention concerne un ensemble de distribution, configuré pour distribuer de l'énergie électrique provenant d'une source de puissance à au moins une charge électrique, la source de puissance comprenant un neutre et au moins une phase, dans lequel :
- l'ensemble de distribution comprend un bus de puissance, qui inclut plusieurs barres conductrices :
   - qui incluent au moins une barre de phase et éventuellement une barre de neutre, la barre de neutre éventuelle étant associée au neutre de la source de puissance, chaque barre de phase étant respectivement associée à une phase de la source de puissance,
   - qui s'étendent parallèlement entre elles selon un axe principal de l'ensemble de distribution et qui sont alignées selon un axe de hauteur qui est orthogonal à l'axe principal,
- les barres conductrices comprennent chacune :
   - une portion d'alimentation, qui est configurée pour être connectée à une borne de sortie d'un boitier principal dans une configuration montée du boitier principal,
   - une portion de connexion, qui s'étend d'un même côté de la portion d'alimentation, les portions de connexion étant géométriquement situées d'un côté avant d'un plan de connexion parallèle à l'axe principal et à l'axe de hauteur et définissant ensemble une zone de connexion du bus de puissance, la zone de connexion étant configurée pour recevoir au moins un boitier de départ de sorte que le boitier de départ est relié au bus de puissance, chaque boitier de départ étant propre à être connecté à une charge électrique, de manière à alimenter la charge électrique en puissance électrique,
- l'ensemble de distribution comprend un dispositif de refroidissement, qui inclut :
   - une plaque de contact, qui présente une face de contact qui s'étend parallèlement au plan de connexion, la face de contact étant configurée pour coopérer, notamment par complémentarité de formes, avec une face arrière du boitier principal en configuration montée, de manière à favoriser le transfert thermique entre la plaque de contact et le boitier principal,
   - un radiateur qui s'étend le long de la zone de connexion, d'un côté arrière du plan de connexion,
   - au moins un caloduc, qui relie la plaque de contact au radiateur et qui est configuré pour transférer au radiateur une partie de la chaleur captée par la plaque de contact, le radiateur étant configuré pour dissiper dans l'air la chaleur transférée par chaque caloduc.

Grâce à l'invention, le volume situé sur l'avant du bus de puissance est destiné à la connexion d'autres appareils, par exemple des dispositifs de protection tels que des boitiers de départ, tandis que le volume situé sur l'arrière du bus de puissance est essentiellement réservé au radiateur, ce qui permet de d'évacuer efficacement une partie de la chaleur générée par le boitier principal en fonctionnement. Entre outre, le dispositif de refroidissement est passif, c'est-à-dire qu'il ne consomme pas d'énergie pour fonctionner, tout en restant silencieux. Le dispositif de refroidissement ne comprend pas de moteur ni aucune pièce en mouvement, réduisant les possibilités de panne, ce qui contribue à la fiabilité du dispositif de refroidissement et, par extension, de l'ensemble de distribution. L'agencement de l'ensemble de distribution est particulièrement compact, tout en offrant une capacité de refroidissement améliorée.

Selon des aspects avantageux mais non obligatoires de l'invention, un tel ensemble de distribution peut incorporer une ou plusieurs des caractéristiques suivantes prises isolément ou selon toute combinaison techniquement admissible :
- L'ensemble de distribution inclut le boitier principal, le boitier principal étant monté sur le reste de l'ensemble de distribution et comprenant :
   - des bornes d'entrée, qui sont configurées pour être reliées au neutre et à chaque phase et au neutre éventuel de la source de puissance,
   - des bornes de sortie, qui sont reliées aux barres conductrices, chaque borne de sortie étant associée à une barre conductrice respective et à une borne d'entrée respective,
   - la face arrière, qui coopère, notamment par complémentarité de formes, avec la face de contact.
- Le boitier principal comprend des moyens de coupure, notamment statiques, qui sont commutables entre une configuration passante, dans laquelle chaque borne d'entrée est électriquement reliée à la borne de sortie associée, le boitier principal étant dans une configuration passante, et une configuration de coupure, dans laquelle le passage d'un courant électrique entre la borne d'entrée et la borne de sortie associée est empêché, le boitier principal étant dans une configuration de coupure,
   alors que le boitier principal comprend une paroi arrière, qui est réalisée en un matériau thermiquement conducteur et électriquement isolant et qui comporte la face arrière, la paroi arrière étant intercalée entre les moyens de coupure et la plaque de contact, de manière qu'une partie de la chaleur générée par les moyens de coupure en fonctionnement est transférée à la plaque de contact au travers de la paroi arrière.
- Le au moins un caloduc est un caloduc diphasique.
- Le au moins un caloduc est un caloduc diphasique de type capillaire, alors que lorsque l'ensemble de distribution est dans une configuration normale de fonctionnement, l'axe principal est horizontal.
- L'ensemble de distribution comprend une paroi isolante, qui est réalisée en un matériau électriquement isolant et qui est intercalée entre le bus de puissance et le radiateur, la paroi isolante étant ouverte vers l'avant de la plaque de contact, alors que les bornes de sortie du boitier principal sont des pinces de raccordement, qui sont chacune prévues pour la connexion à une barre conductrice respective, selon un mouvement de connexion orienté vers l'arrière de l'ensemble de distribution, de sorte que, au cours du mouvement de connexion des bornes de sortie aux barres conductrices, la face arrière du boitier principal vient en appui contre la face de contact.
- L'ensemble de distribution comprend une portion arrière, qui ménage une cavité de réception du dispositif de refroidissement, la portion arrière étant réalisée en un matériau électriquement isolant,
   alors que la portion arrière est ajourée, de manière à favoriser le refroidissement, par convection, du dispositif de refroidissement.

L'invention concerne aussi un tableau électrique, comprenant :
- un coffre, délimitant une enceinte et présentant un fond,
- l'ensemble de distribution tel que défini précédemment,
dans lequel l'ensemble de distribution est fixé sur le fond du boitier, l'axe principal étant parallèle au fond du coffre, de préférence horizontal.

L'invention sera mieux comprise, et d'autres avantages de celle-ci apparaîtront plus clairement à la lumière de la description qui va suivre, d'un mode de réalisation d'un ensemble de distribution et d'un tableau électrique, conformes à son principe, donnée uniquement à titre d'exemple et faite en référence aux dessins annexés, dans lesquels :
- [Fig 1] la figure 1 est une vue en perspective partiellement éclatée un tableau électrique conforme à l'invention, le tableau électrique comprenant un ensemble de distribution, lui-aussi conforme à l'invention ;

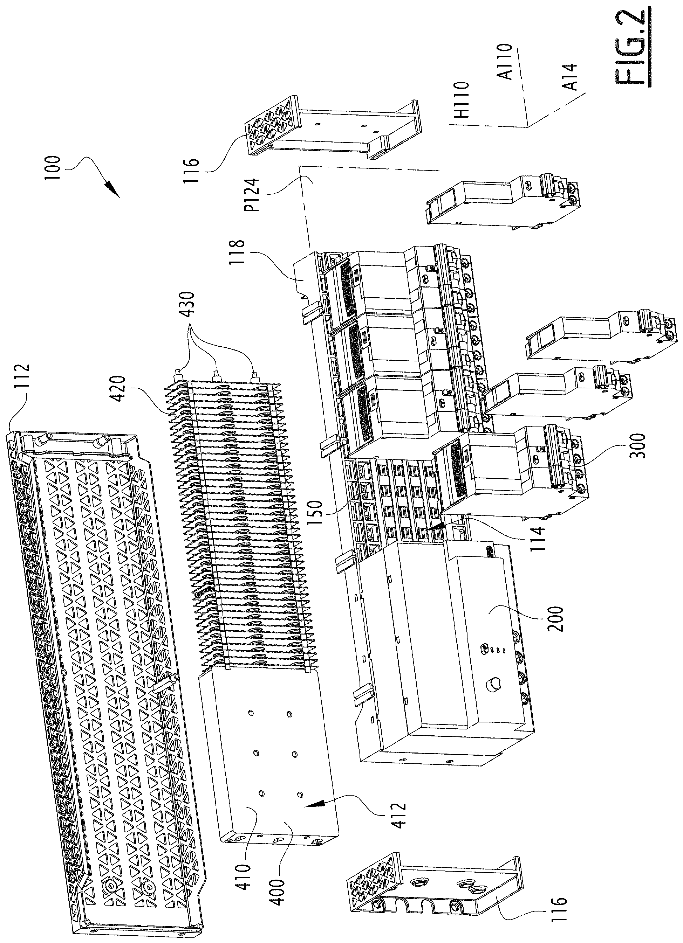

- [Fig 2] la figure 2 est une vue en perspective partiellement éclatée de l'ensemble de distribution de la figure 1 ;
- [Fig 3] la figure 3 représente respectivement, sur deux inserts a) et b), une vue en perspective de l'ensemble de distribution de la figure 1, certaines pièces étant cachées, et une vue en perspective d'un bus de transfert de l'ensemble de distribution,
- [Fig 4] la figure 4 est une vue en perspective partiellement éclatée de l'ensemble de distribution de la figure 1, certaines pièces étant cachées, et
- [Fig 5] la figure 5 est une représentation schématique de l'ensemble de distribution de la figure 1.

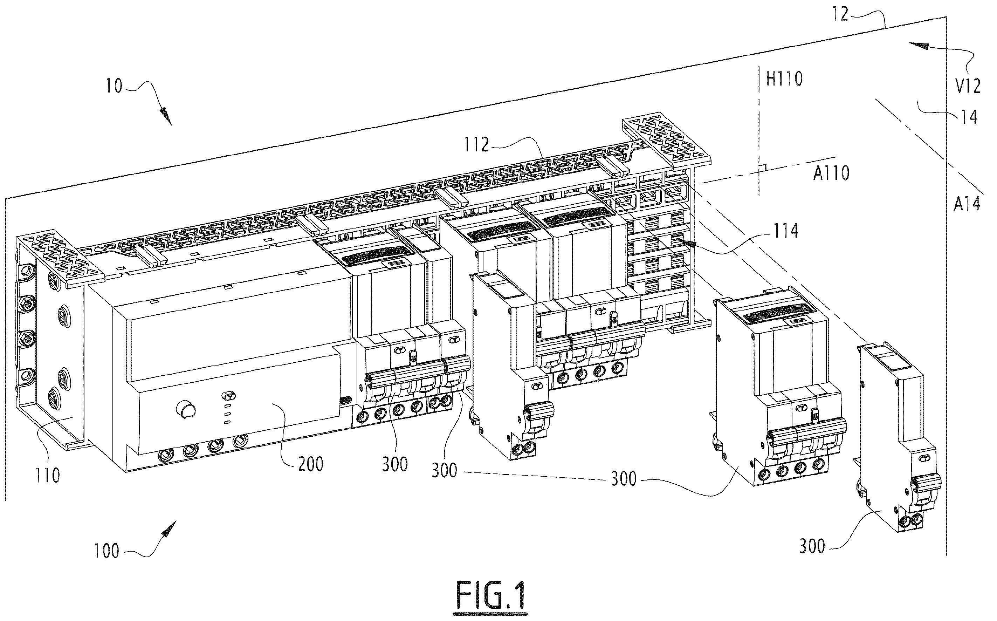

Un tableau électrique 10, conforme à l'invention, est représenté à la figure 1. Le tableau électrique 10 comprend un coffre 12, qui délimite une enceinte V12 et qui présente un fond 14. Le fond 14 s'étant globalement dans un plan orthogonal à un axe de profondeur A14. L'enceinte V12 est avantageusement refermée par une porte, qui n'est pas représentée.

Le tableau électrique 10 comprend un ensemble de distribution 100. L'ensemble de distribution 100 est fixé sur le fond 14 du boitier 12. 1. L'ensemble de distribution 100 est configuré pour distribuer de l'énergie électrique provenant d'une source de puissance à au moins une charge électrique, la source de puissance comprenant un neutre et au moins une phase. La source de puissance et la charge électrique, qui ne sont pas représentées, ne font pas partie de l'invention mais servent à en expliquer le contexte de fonctionnement.

L'ensemble de distribution 100 comprend un dispositif de distribution 110, par lequel l'ensemble de distribution 100 est fixé sur le fond 14, un boitier principal 200, qui est assemblé au dispositif de distribution 110, de préférence de manière réversible, et au moins un boitier de départ 300, ici sept boitiers de départ, chaque boitier de départ 300 étant assemblé au dispositif de distribution 110 de manière réversible, dans une position montée du dispositif de départ 300. Il est ainsi possible de remplacer, au besoin, le boitier principal 200 en cas de dysfonctionnement du boitier principal 200, tout en conservant les autres éléments de l'ensemble de distribution 100, dispositif de distribution 110 et boitier(s) de départ 300, ce qui est économique. De même, il est possible de remplacer, au besoin, un ou plusieurs des boitiers de départ 300, par exemple en cas de dysfonctionnement, tout en conservant les autres éléments, dispositif de distribution 110 et boitier principal 200, ce qui est économique.

Le dispositif de distribution 110 présente une forme allongée, qui s'étend selon un axe principal A110. Lorsque l'ensemble de distribution 100 est dans une configuration normale de fonctionnement, l'axe principal A110 est parallèle au fond 14, autrement dit orthogonal à l'axe de profondeur A14. De préférence, l'axe principal A110 est horizontal, comme illustré à la figure 1. On définit un axe de hauteur H110 comme étant un axe orthogonal à la fois à l'axe de profondeur A14 et à l'axe principal A110. La description est faite en regarde de l'orientation des divers éléments tels que représentés sur les figures, sachant qu'il peut en être autrement dans la réalité.

Dans l'exemple de la figure 1, le boitier principal 200 est situé sur la gauche de l'ensemble de distribution 100, les boitiers de départ 300 étant situé sur la droite du boitier principal 200.

Lorsque l'ensemble de distribution 100 est fixé sur le fond 14, une portion arrière 112 du dispositif de distribution 110 est orientée en regard du fond 14, autrement dit orientée vers une direction arrière de l'ensemble de distribution 100. La direction arrière est ainsi parallèle à l'axe de profondeur A14. On définit également une direction avant comme étant une direction opposée à la direction arrière.

Le dispositif de distribution 110 présente ainsi une face de montage 114, qui est globalement orientée vers l'avant et qui est prévue pour le montage du boitier principal 200 et de chaque boitier de départ 300.

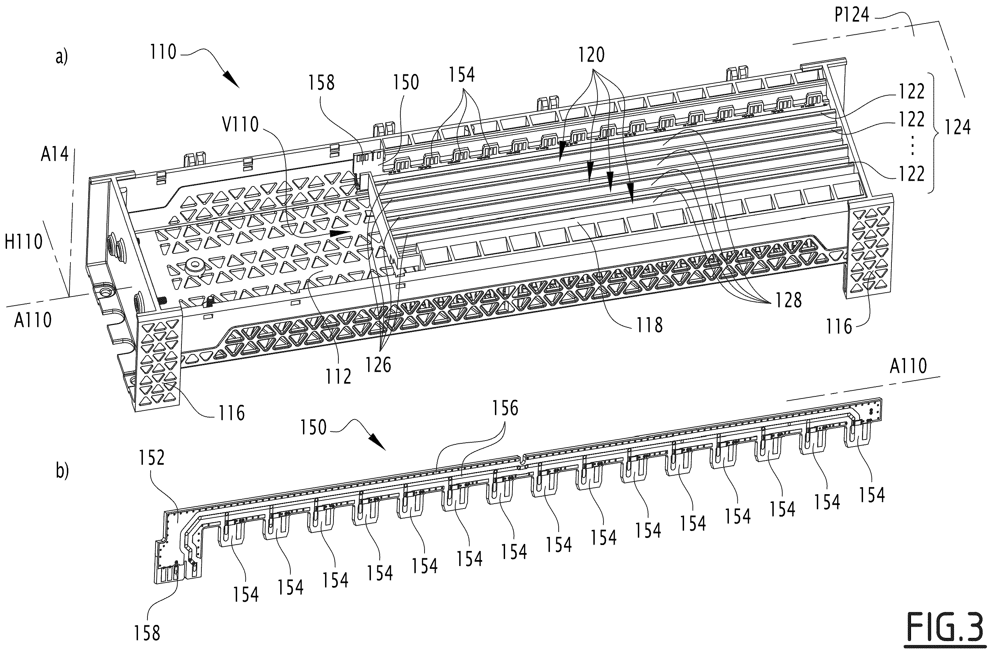

La portion arrière 112 est réalisée en un matériau électriquement isolant, par exemple en polymère synthétique. La portion arrière 112 présente ici une forme globalement rectangulaire, qui s'étend dans sa plus grande dimension parallèlement à l'axe principal A110. Les petits côtés du rectangle sont ainsi parallèles à l'axe de hauteur H110. Le dispositif de distribution 110 comprend ici deux flasques 116, qui sont réalisés en un matériau électriquement isolant. Les deux flasques 116 sont assemblés aux petits côtés de la portion arrière 112 de manière à former un panier,
Le dispositif de distribution 110 comprend ici une paroi isolante 118, qui est réalisée en un matériau électriquement isolant et qui est assemblée à la portion arrière 112 et aux flasques 116, de manière à former une cavité V110, comme illustré à la figure 3.

Selon un aspect de l'invention, le dispositif de distribution 110 comprend un dispositif de refroidissement 400, qui est reçu dans la cavité V110 et qui est prévu pour évacuer une partie de la chaleur générée par le boitier principal 200 lorsque l'ensemble de distribution 100 est en fonctionnement. Le dispositif de refroidissement 400 est ainsi situé d'un côté arrière de la paroi isolante 118, tandis que d'un côté avant de la paroi isolante 118, le côté avant étant orienté à l'opposé du côté arrière, la paroi isolante 118 ménage des sillons 120 prévus pour recevoir plusieurs barres conductrices 122. Les barres conductrices 122 forment ensemble un bus de puissance 124 du dispositif de distribution 110 et, par extension, de l'ensemble de distribution 100. La portion arrière 112 est préférentiellement ajourée, de manière à favoriser le refroidissement, par convection, du dispositif de refroidissement 400. Le dispositif de distribution 110 forme ainsi une cage autour du dispositif de refroidissement 400.

Les barres conductrices 122 incluent au moins une barre de phase et, éventuellement, une barre de neutre, la barre de neutre étant associée au neutre de la source de puissance, chaque barre de phase étant associée à une phase respective de la source de puissance. Dans l'exemple illustré, le bus de puissance 124 comprend quatre barres conductrices 122, la source de puissance étant une source triphasée avec un neutre. L'ensemble de distribution 100 présente ici une configuration dite « 3P+N », ou simplement 3PN.

En variante non représentée, la source de puissance est triphasée, avec ou sans neutre, tandis que l'ensemble de distribution ne comprend pas de barre conductrice associée au neutre. Autrement dit, l'ensemble de distribution ne comprend que trois barres de phases, chacune associée à une phase respective de la source de puissance. L'ensemble de distribution est alors dans une configuration dite 3P.

Les principes de l'invention sont transposables quel que soit le nombre de phases de la source de puissance. Selon une autre variante non illustrée, la source de puissance est monophasée, c'est-à-dire ne comprend que le neutre et une seule phase. Les barres conductrices incluent alors une seule barre de phase, et la barre de neutre. L'ensemble de distribution est alors dans une configuration dite P+N, ou simplement PN. Quelles que soient les configurations, on a toujours plusieurs barres conductrices, qui incluent au moins une barre de phase, et éventuellement une barre de neutre.

Les barres conductrices 122 s'étendent parallèlement entre elles selon l'axe principal A110 de l'ensemble de distribution 100 et sont alignées selon l'axe de hauteur H100. Les barres conductrices 122 définissent ensemble un plan de connexion P124, qui est un plan orthogonal à l'axe de profondeur A14, autrement dit parallèle à l'axe de hauteur H110 et à l'axe principal A110. La face de montage 114 est globalement parallèle au plan de connexion P124.

Le dispositif de refroidissement 400 comprend une plaque de contact 410, qui est prévue pour capter une partie de la chaleur dégagée par le boitier principal 200, un radiateur 420, qui est prévu pour dissiper de la chaleur dans l'air ambiant, et au moins un caloduc 430, ici trois caloducs, qui relie la plaque de contact 410 au radiateur 420 et qui est configuré pour transférer au radiateur 420 une partie de la chaleur captée par la plaque de contact 410.

La plaque de contact 410 présente ici une forme de parallélépipède et présente une face de contact 412, qui s'étend parallèlement au plan de connexion P124. La face de contact 412 est configurée pour coopérer, notamment par complémentarité de formes, avec une face arrière 230 du boitier principal 200 en configuration montée sur le dispositif de distribution 110, de manière à favoriser le transfert thermique entre la plaque de contact 410 et le boitier principal 200.

Le radiateur 420 est ici formé d'un ensemble d'ailettes métalliques, qui sont positionnées de manière à ne pas gêner le passage de l'air. Les ailettes métalliques sont ici positionnées parallèlement les unes aux autres et sont alignées selon l'axe principal A110. Les caloducs 430 relient les ailettes à la plaque de contact 410.

De manière générale, un caloduc est un dispositif destiné à transporter la chaleur grâce au principe du transfert thermique, par exemple par conduction thermique, ou bien par convection d'un fluide, ou bien encore par transition de phases d'un fluide. Selon des exemples, les caloducs 430 sont des tiges de métal, par exemple des tiges de cuivre. De préférence, les caloducs 430 sont des caloducs diphasiques. Dans l'exemple illustré, les caloducs 430 sont des caloducs diphasiques de type capillaires. Généralement, un caloduc diphasique de type capillaire comprend deux tubes coaxiaux, qui sont agencés de manière à favoriser en leur sein une circulation d'un fluide caloporteur changeant de phase, liquide ou gazeuse, en fonction de sa température. De préférence, les caloducs 430 diphasiques capillaires sont rectilignes et sont agencés horizontalement lorsque l'ensemble de distribution 100 est dans une configuration normale de fonctionnement. Autrement dit, l'axe principal A110 est de préférence horizontal. En variante non illustrée, les caloducs 430 diphasiques sont des caloducs de type « gravitaire », qui sont préférentiellement agencés verticalement. Autrement dit, dans ce cas l'axe principal A110 est de préférence vertical.

Ainsi, le radiateur 420 s'étend le long de la zone de connexion du bus de puissance 124, d'un côté arrière du plan de connexion P124. En particulier, le radiateur 420 est situé du côté arrière de la paroi isolante 118, le radiateur 420 étant reçu dans la cavité V110, tandis que la paroi isolante 118 est ouverte vers l'avant de la plaque de contact 410. Autrement dit, la paroi isolante 118 est intercalée entre le bus de puissance 124 et le radiateur 420. La portion de la paroi isolante 118 servant de support aux barres conductrices 122 est de préférence continue, de manière à réduire les risques d'arc électrique entre les barres conductrices 122 et le radiateur 420.

Les barres conductrices 122 incluent une barre de neutre et au moins une barre de phase, la barre de neutre étant associée au neutre de la source de puissance, chaque barre de phase étant associée à une phase respective de la source de puissance. Dans l'exemple illustré, le bus de puissance 124 comprend quatre barres conductrices 122, la source de puissance étant une source triphasée. Les principes de l'invention sont transposables quel que soit le nombre de phases de la source de puissance, en particulier si la source de puissance est monophasée, c'est-à-dire ne comprend que le neutre et une seule phase.

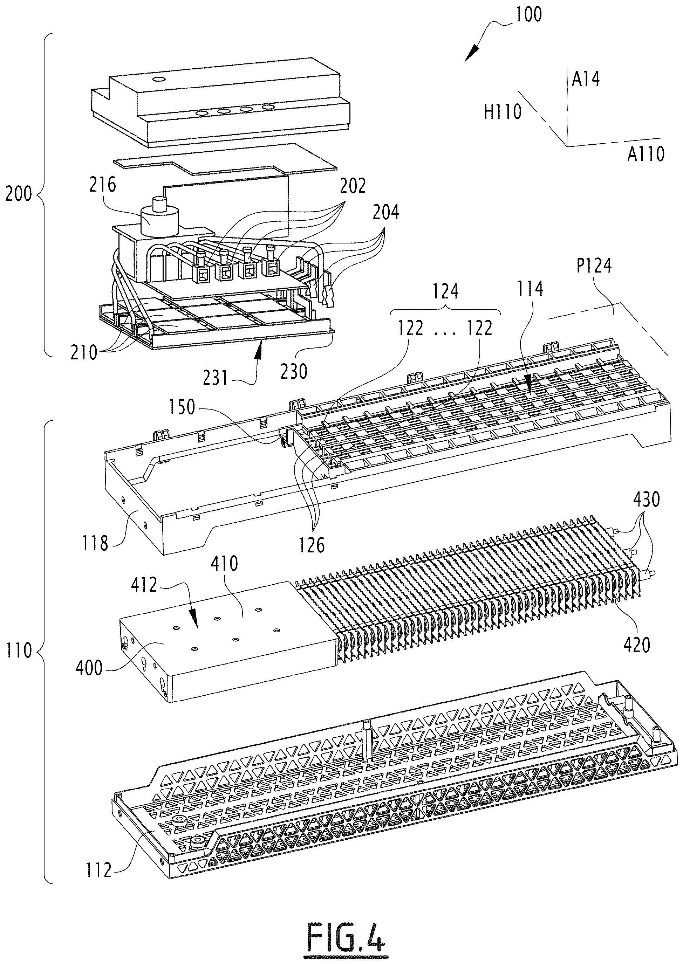

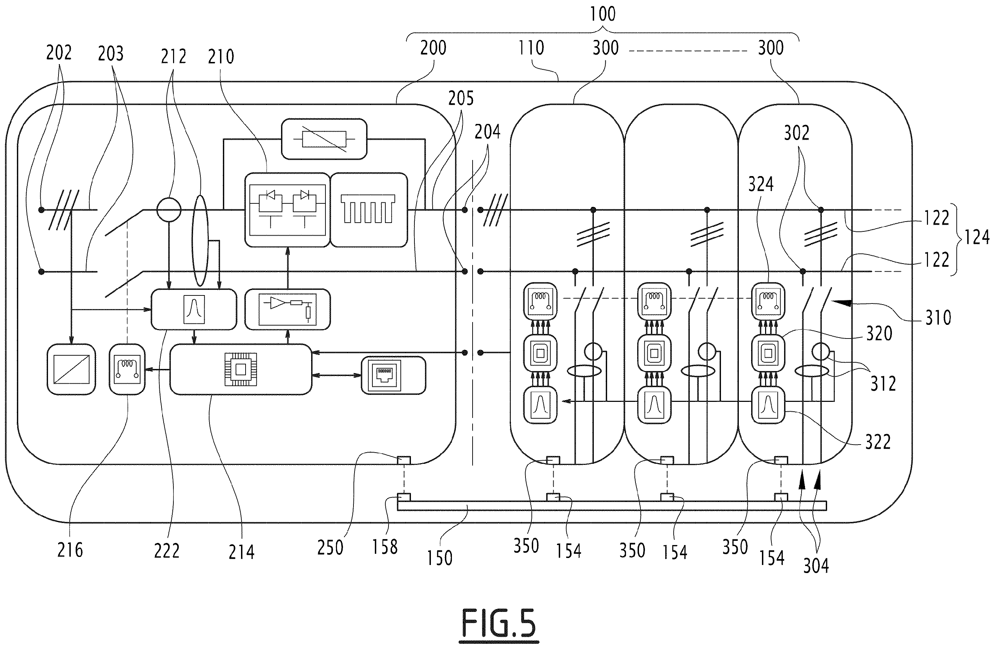

On décrit à présent le boitier principal 200, notamment en référence aux figures 4 et 5. Sur la figure 5, le circuit d'une seule phase est représenté, les trois phases étant représentées, selon une convention connue, par trois traits parallèles en travers du circuit.

Le boitier principal 200 comprend des bornes d'entrées 202, qui sont configurées pour être relié au neutre et à chaque phase de la source de puissance, et des bornes de sorties 204, qui sont configurées pour être reliées aux barres conductrices, chaque borne de sortie étant associée à une barre conductrice respective et à une borne d'entrée respective. Les bornes d'entrée 202 sont ici des bornes à vis. Avantageusement, les bornes de sortie 204 sont des pinces de raccordement, qui sont chacune prévues pour la connexion réversible à une barre conductrice122 respective, selon un mouvement de connexion orienté vers l'arrière de l'ensemble de distribution 100. Ainsi, au cours du mouvement de à la connexion des bornes de sortie 204 aux barres conductrices 122, la face arrière du boitier principal 200 vient en appui contre la face de contact 412.

Pour chaque borne d'entrée 202, le boitier principal comporte une ligne d'entrée 203 correspondante, qui est reliée à la borne d'entrée 202 correspondante, et une ligne de sortie 205, qui est reliée à la borne de sortie 204 associée.

Le boitier principal 200 comprend des moyens de coupure statiques 210, qui sont commutables entre une configuration passante, dans laquelle chaque borne d'entrée 202 associée à une phase de la source de puissance est électriquement reliée à la borne de sortie 204 associée, le boitier principal 200 étant dans une configuration passante, et une configuration de coupure, dans laquelle le passage d'un courant électrique entre la borne d'entrée 202 et la borne de sortie 204 associée est empêché, le boitier principal 200 étant dans une configuration de coupure.

Les moyens de coupure statiques 210 sont des interrupteurs de puissance base de composants semi-conducteurs, de préférence des transistors à effet de champ à grille isolée, ou MOSFET, et sont ainsi dits « statiques » par opposition aux moyens de coupure à contact mobile. Les moyens de coupure statiques 210 sont branchés en série entre la ligne d'entrée 203 et la ligne de sortie 205 associée. Les moyens de coupure statique 210 sont représentés schématiquement aux figures 4 et 5.

En fonctionnement, les moyens de coupure 210 dégagent de la chaleur, de l'ordre de quelques dizaines de Watts chacun. Les moyens de coupure 210 sont avantageusement disposés de manière à favoriser le transfert d'au moins une partie de la chaleur dégagée vers le dispositif de refroidissement 400.

En particulier, les moyens de coupure 210 sont avantageusement agencés contre une paroi arrière 231 du boitier principal 200, de préférence en contact surfacique contre la paroi arrière 231. La paroi arrière 231 ménage la face arrière 230, la face arrière 230 étant orientée à l'opposé des moyens de coupure 210. La paroi arrière 231 est ainsi intercalée entre les moyens de coupure 210 et la plaque de contact 410 lorsque la boitier principal 200 est monté sur le dispositif de distribution 110, de manière qu'une partie de la chaleur générée par les moyens de coupure 210 en fonctionnement est transférée à la plaque de contact 410 au travers de la paroi arrière.

La paroi arrière 231 est réalisée en un matériau thermiquement conducteur et électriquement isolant. Dans l'exemple illustré, la paroi arrière 231 est formée d'un assemblage d'une plaque électriquement isolante, réalisée en matériau polymère synthétique, et d'une plaque de cuivre, qui apporte rigidité à l'ensemble tout en favorisant la conduction thermique, la plaque de cuivre ménageant la face arrière 230 et étant en appui contre la plaque de contact 410 lorsque le boitier principal 200 est monté sur le dispositif de distribution 110.

Le boitier principal 200 comprend des moyens de détection principaux 212, qui sont configurés pour mesurer des grandeurs électriques aux bornes de sortie et pour détecter un défaut électrique en fonction des valeurs mesurées. Les moyens de détection principaux 212 sont ici représentés par des boucles de mesures, qui sont ici agencés sur les lignes de sortie 205. De préférence, les moyens de détection principaux 212 incluent un dispositif de détection de courant différentiel.

Le boitier principal 200 est configuré pour passer de la configuration passante à la configuration de coupure lorsque les moyens de détection principaux 212 détectent un premier défaut électrique.

Le boitier principal 200 comprend une unité de contrôle 214, ou ECU en anglais pour *Electronic Control Unit*, qui est configurée pour piloter les moyens de coupure statiques 210, autrement dit pour faire commuter les moyens de coupure statiques 210 entre la configuration passante et la configuration de coupure. L'unité de contrôle 214 est également configurée pour analyser les valeurs mesurées par les moyens de détection principaux 212 et pour déterminer, en fonction de critères prédéfinis correspondant à un type prédéterminé de défaut électrique, la présence d'un défaut électrique du type prédéterminé. À la figure 5, l'utilisation de critères prédéfinis est représentée schématiquement par la présence d'un filtre dit « primaire » 222, le filtre primaire 222 étant est intercalé entre les moyens de détection principaux 212 et l'unité de contrôle 214. Il existe plusieurs types de défauts différentiels, qui sont définis notamment dans la norme IEC 60755:2017. En particulier, les types de défauts électriques incluent le fait que le signal électrique soit redressé, que le signal inclut une composante à haute fréquence, le calibre - par exemple 30 mA ou 300 mA -... On comprend que le filtre primaire 222 définit des critères de détection des défauts électriques par l'unité de contrôle 214 du boitier principal 200. De préférence, le filtre primaire 222 définit des critères de détection d'un type de défaut différentiel prédéterminé, le défaut préférentiel prédéterminé étant choisi parmi les défauts définis dans la norme IEC 60755:2017.

On définit un délai de coupure ΔC comme étant un intervalle de temps entre l'instant de la détection du défaut électrique et le passage en configuration de coupure. Le délai de coupure ΔC inclut ainsi le temps nécessaire pour analyser les mesures réalisées par les moyens de détection principaux, le temps nécessaire pour envoyer un ordre d'ouverture aux moyens de coupure statiques 210, et le temps de coupure des moyens de coupure statiques 210 une fois que l'ordre d'ouverture est envoyé. Typiquement, le temps de coupure des moyens de coupure statiques 210 dépend de la structure des moyens de coupure statiques et est inférieur à 1 microseconde - µs -. Ainsi le délai de coupure ΔC est essentiellement lié au fonctionnement de l'unité de contrôle 210. Typiquement, le délai de coupure ΔC est de l'ordre de la microseconde ou de la dizaine de microsecondes, par exemple compris entre 5 µs et 500 µs.

De préférence, le boitier principal 202 comprend aussi, pour chaque borne d'entrée 202, un dispositif de coupure générale 216, qui est un dispositif de coupure à contacts séparables, ici un sectionneur. Le dispositif de coupure générale 216 est piloté par l'unité électronique de contrôle 214 et permet déconnecter électriquement la source de puissance de l'ensemble de distribution 100, par exemple en cas de dysfonctionnement des moyens de coupure statiques 210. Le dispositif de coupure générale 216 est intercalé chaque borne d'entrée 202 et les moyens de coupure statiques 210.

Avantageusement, le dispositif de distribution 110, et par extension l'ensemble de distribution 100, comprend aussi un bus de transfert 150. Le bus de transfert 150, qui est représenté isolément à la figure 3 b), est prévu pour le fonctionnement pour alimenter en énergie chaque boitier de départ 300 en position montée, c'est-à-dire connecté aux barres conductrices 122. Le bus de transfert 150 est donc ici un bus de transfert d'énergie, autrement dit un bus d'alimentation, qui est distinct du bus de puissance 124. Selon un exemple illustratif, le bus de transfert 150 fonctionne sous une tension de quelques dizaines de Volts, par exemple 50 V en continu, tandis que le bus de puissance 124 fonctionne sous une tension de 400 V en triphasé alternatif. Le bus de transfert 150 est ici une pièce distincte, qui est assemblée au reste du dispositif de distribution 110.

Le bus de transfert 150 comprend un corps 152, qui est réalisé en un matériau électriquement isolant, qui présente une forme allongée s'étendant le long du bus de puissance 124. Ainsi le bus de de transfert 150 s'étend le long de l'axe principal A110.

Le bus de transfert 150 définit plusieurs zones de montage 154, qui sont prévues pour être connectées à chaque boitier de départ en position montée, les zones de montage 154 étant réparties, de préférence régulièrement, le long de l'axe principal A110 et étant chacune associée à une position unique le long de l'axe principal A110. Le bus de transfert 150 comprend préférentiellement quinze zones de montage, qui sont espacées les unes des autres d'un pas de 18 mm. D'autres pas sont bien entendu possibles. En variante non représentée, les zones de montages 154 sont espacées les unes des autres d'un pas de 9 mm.

Le bus de transfert 150 comprend au moins deux lignes de transfert 156, qui s'étendent le long du corps 152 est qui sont configurées pour être électriquement connectées à chaque boitier de départ 300 en position montée. Les lignes de transfert 156 sont ici des lignes d'alimentation, le bus de transfert 150 étant ainsi un bus d'alimentation, qui est configuré pour fournir de l'énergie de fonctionnement à chaque boitier de départ 300, en particulier à l'alimentation du microcontrôleur 320 de chaque boitier de départ 300. En variante non illustrée, le bus de transfert 150 sert aussi au transfert des données entre chaque microcontrôleur 320 et l'unité de contrôle du boitier principal 200. Par exemple, le transfert d'information passe par les mêmes lignes de transfert 156 utilisées pour le transfert d'énergie. En alternative non illustrée, le bus de transfert 150 comprend des lignes de transfert d'information spécifiques, différentes des lignes de transfert 156, qui sont managées sur le bus de transfert 150. Selon une autre alternative, les lignes de transfert 156 servent à la fois à la transmission d'énergie et à la transmission d'information.

Le bus de transfert 150 comprend également une zone de connexion 158, qui est prévue pour la connexion du boitier principal 200 en position montée sur l'ensemble de distribution 110. Par exemple, le boitier principal 200 comprend un bornier complémentaire 250, qui est configuré pour coopérer avec la zone de connexion 158, de sorte que le boitier principal est électriquement connecté aux lignes de transfert 156. Dans l'exemple préférentiel illustré, le boitier principal 200 prélève de l'énergie électrique nécessaire à l'alimentation du bus de transfert 150 sur le neutre et les phases de la source de puissance, entre les moyens de coupure statique 210 et le dispositif de coupure générale 216, l'énergie électrique ainsi fournie étant à disposition des boitiers de départ 300 pour leur fonctionnement.

Le bus de transfert 150 est ici réalisé par une carte de circuit imprimé, les lignes de transfert 156 étant des pistes conductrices ménagées en surface de la carte, tandis que les zones de montage 154 et la zone de connexion 158 sont des pattes ménagées dans le substrat de la carte.

On décrit à présent les boitiers de départ 300.

Chaque boitier de départ 300 comprend ainsi un bornier d'arrivée qui est connectable aux barres conductrices 122 de manière réversible et qui comprend au moins deux bornes d'arrivée 302, chaque borne d'arrivée 302 étant configurée pout être électriquement connectée à une barre conductrice 122 respective. Pour chaque boitier de départ 300, les bornes d'arrivée 302 qui incluent une borne d'arrivée neutre, qui est configurée pour être électriquement connectée à la barre neutre, et entre une et trois autres bornes d'arrivée, qui sont chacune configurées pour être connectée à une barre de phase respective. Chaque boitier de départ 300 est configuré pour être monté, de manière réversible, sur le bus de puissance 114, de sorte que chaque borne d'arrivée 302 est électriquement reliée à la barre conductrice 122 correspondante.

Chaque boitier de départ 300 comprend aussi un bornier de départ, qui est configuré pour être connecté à une charge électrique et qui comprend des bornes de départ 304, chaque borne de départ 304 étant respectivement associée à une borne d'entrée 302 respective. Les bornes de départ 304 sont représentées schématiquement à la figure 5.

Dans l'exemple non limitatif illustré, les boitiers de départs 300 présentent des largeurs différentes, la largeur étant mesurée selon l'axe principal A110. Ainsi les boitiers de départs 300 sont répartis en deux sous-groupes, qui correspondent à deux largeurs différentes, avec des boitiers de départs 300 fins et des boitiers de départ 300 larges, qui sont sensiblement trois fois plus larges que les boitiers de départ 300 fins. D'autres largeurs de boitiers de départ 300 sont bien entendu envisageables. La largeur des boitiers de départ 300 est de préférence un multiple du pas entre chaque zone de montage 154 du bus de transfert 150, soit ici 18 mm. En variante non représentée, les boitiers de départ 300 ont une largeur égale à un multiple de 9 mm.

Dans l'exemple illustré, un boitier de départ 300 configuré pour alimenter une charge électrique monophasée présente avantageusement une largeur de 18 mm, tandis qu'un boitier de départ 300 configuré pour alimenter une charge électrique triphasée présente une largeur de trois fois 18 mm, soit 54 mm.

Les boitiers de départs 300 les plus fins sont configurés pour être connectés à deux barres conductrices 122, incluant une barre neutre et une barre de phase, tandis que les boitiers de départs 300 larges sont configurés pour être connectés à quatre barres conductrices 122. Les principes de l'invention sont applicables quel que soit le nombre de phases auxquelles sont connectés chacun des boitiers de départ 300.

De préférence, le dispositif de distribution 110 est prévu pour recevoir cinq boitiers de départs 300, qui comprennent chacun quatre bornes d'arrivées, autrement dit cinq boitiers de départs 300 larges. Selon un exemple non illustré, l'ensemble de distribution 100 comprend cinq boitiers de départs 300, qui comprennent chacun quatre bornes d'arrivées 302. En corolaire, le dispositif de distribution 110 est également prévu pour recevoir quinze boitiers de départs 300 fins comprenant chacun deux bornes d'arrivée 302. Les barres conductrices 122 comprennent chacune :
- une portion d'alimentation 126, qui est configurée pour être connectée à une borne de sortie 204 associée du boitier principal 200 dans une configuration montée du boitier principal, et
- une portion de connexion 128, qui s'étend d'un même côté de la portion d'alimentation 126. Les portions de connexion 128 sont géométriquement situées d'un côté avant du plan de connexion P124 et définissent ensemble une zone de connexion du bus de puissance 124.

À la figure 4, seules les portions d'alimentation 126 des barres conductrices 122 sont visibles, les portions de connexion 128 étant cachées. La zone de connexion est configurée pour recevoir au moins un boitier de départ 300, de sorte que le boitier de départ est relié au bus de puissance 129. Le boitier de départ 300 est alors propre à être connecté à une charge électrique, de manière à alimenter la charge électrique en puissance électrique.

Chaque boitier de départ 300 comprend des moyens de coupure électromécaniques 310, qui sont intercalés entre chaque borne d'arrivée 302 et la borne de départ 304 correspondante. Les moyens de coupure électromécaniques 310 comprennent des contacts séparables, qui sont déplaçables entre une position fermée, dans laquelle chaque borne d'arrivée 302 est électriquement reliée à la borne de départ 304 associée, le boitier de départ 300 concerné étant dans une configuration fermée, et une position ouverte, dans laquelle le passage d'un courant électrique entre la borne d'arrivée 302 et la borne de départ 304 associée est empêché, le boitier de départ 300 concerné étant dans une configuration ouverte.

Chaque boitier de départ 300 comprend des moyens de détection secondaires 312, qui sont configurés pour mesurer des grandeurs électriques aux bornes de départ correspondantes et pour détecter au moins un défaut électrique d'un type prédéterminé, c'est-à-dire correspondant à des critères de détection prédéterminés. Les moyens de détection secondaires 312 sont ici représentés schématiquement par des boucles de mesures, qui sont ici agencés sur les fils reliant les bornes d'arrivée 302 aux bornes de départ 304. La représentation schématique des moyens de détection secondaires 312 ne limite pas le type de défauts électriques que les moyens de détection secondaires sont aptes à détecter. Ainsi, les moyens de détection secondaires 312 sont configurés pour détecter les défauts électriques de type courts-circuits.

Par exemple, les moyens de détection secondaires 312 incluent des capteurs de courant, en particulier un capteur de courant par phase, tandis que le boitier de départ 300 comprend un microcontrôleur 320, qui reçoit les mesures des capteurs de courant et qui est apte à déterminer si le ou les courants mesurés dépassent un seuil de court-circuit.

En alternative ou en complément, les moyens de détection secondaires 312 incluent un dispositif de détection de courant différentiel. De préférence, le boitier de départ 300 comprend un microcontrôleur 320, qui est configuré pour évaluer la mesure de courant différentiel à l'aide d'un filtre dit « secondaire » 322, le filtre secondaire 322 étant préalablement enregistré dans une mémoire du microcontrôleur 320 du boitier de départ 300 et étant adapté pour la détection d'un défaut différentiel.

Le microcontrôleur 320 est alimenté par l'intermédiaire du bus de transfert 150. À cet effet, chaque boitier de départ 300 comprend un bornier de transfert 350, qui comprend des bornes de transfert - non représentées -, le bornier de transfert 350 étant configuré pour être connecté au bus de transfert 150 de sorte que chaque borne de transfert est électriquement connectée à une ligne de transfert 156 respective. Le bornier de transfert 350 est donc ici un bornier d'alimentation. Les bornes de transfert sont différentes des bornes d'arrivée 302 ou des bornes de départ 304.

On comprend que le filtre secondaire 322 définit les critères de détection des défauts électriques détectés par le microcontrôleur 320 du boitier de départ 300. De préférence, le filtre secondaire 322 définit des critères de détection d'un type de défaut différentiel prédéterminé, qui est choisi parmi les défauts définis dans la norme IEC 60755:2017.

Chaque microcontrôleur 320 est alimenté en énergie électrique de fonctionnement par l'intermédiaire du bus de transfert 150, indépendamment de la configuration, armée ou déclenchée, du mécanisme de commutation, ici les moyens de coupure électromécaniques 310, du boitier départ 300.

Chaque boitier de départ 300 comprend ici un actionneur 324, qui est configuré pour déplacer les moyens de coupure électromécaniques 310 dans la position ouverte lorsque l'actionneur reçoit un signal de déclenchement, le microcontrôleur 320 étant configuré pour envoyer à l'actionneur 324 le signal de déclenchement lors de la détection d'un défaut électrique, notamment un défaut de court-circuit ou un défaut différentiel. Plus généralement, chaque boitier de départ 300 est configuré pour passer de la configuration fermée à la configuration ouverte lorsque les moyens de détection secondaires 312 - et par extension le microcontrôleur 320 - détectent un défaut électrique.

On décrit le fonctionnement de l'ensemble de protection 100 dans le cas d'un défaut de court-circuit, ce fonctionnement étant transposable à d'autres types de défauts électriques, notamment aux défauts différentiels. On définit un délai d'ouverture ΔO comme étant un intervalle de temps entre l'instant de la détection du défaut électrique et le début du mouvement des contacts séparables des moyens de coupure électromécaniques 310, de la position fermée vers la position ouverte. Dans l'exemple illustré, le délai d'ouverture inclut le délai du traitement des mesures par le microcontrôleur 320, ainsi que le temps pour que le microcontrôleur 320 envoie l'ordre de coupure à l'actionneur 324. Typiquement, le délai d'ouverture ΔO est de l'ordre de la milliseconde, par exemple de 1 ms à 9 ms.

Dans une configuration minimale de l'ensemble de distribution 100, l'ensemble de distribution comprend le dispositif de distribution 110, sur lequel sont montés le boitier principal 200 et un seul boitier de départ 300. On suppose que l'ensemble de distribution 100 est relié à une source de puissance, par l'intermédiaire des bornes d'entrée 202, tandis qu'une charge électrique est connectée aux bornes de départ 304.

Dans une configuration de fonctionnement normal, le boitier principal 200 est initialement dans la configuration passante, tandis que le boitier de départ 300 est initialement dans la configuration fermée. Ainsi, les bornes de départ 304 sont chacune électriquement reliées à une borne de sortie 204 respective, par l'intermédiaire de la barre conductrice 122 associée. Lorsqu'un défaut électrique survient, par exemple en raison d'une défaillance de la charge électrique, le défaut électrique est détectable à la fois par le boitier principal 200, au moyen des moyens de détection principaux 212, et par le boitier de départ 300, au moyen des moyens de détection secondaires 312.

Autrement dit, les critères de détection de défaut électrique utilisés du boitier principal 200 sont identiques au critère de détection de défaut électrique utilisés par le boitier de départ 300 considéré.

De nombreux types de défauts électriques sont envisageables. À titre d'illustration, en cas de court-circuit, un courant de court-circuit peut atteindre plusieurs fois, par exemple 5 fois, la valeur d'un courant nominal de fonctionnement. D'autres exemples de défauts électriques incluent les surintensités, les défauts de courant différentiels, etc. En comparaison avec les défauts de courts circuits, les courants électriques impliqués dans le cas des surintensités ou des défauts différentiels sont bien moindres, par exemple inférieurs à 1,2 fois la valeur du courant nominal de fonctionnement.

Dans l'exemple illustré, les critères de détection sont définis par les filtres de détection, soit ici le filtre primaire 222 pour le boitier principal 200, et le filtre secondaire 322 pour le boitier de départ 300. Dans le cas d'un défaut de court-circuit, on suppose que le filtre primaire 222 et le filtre secondaire 322 définissent fonctionnellement les mêmes critères de détection, autrement dit que le filtre primaire 222 et que le filtre secondaire 322 sont fonctionnellement identiques l'un à l'autre, de sorte que le boitier principal 200 et le boitier de départ 300 sont configurés pour détecter des défauts électriques selon les mêmes critères.

L'ensemble de distribution 100 est configuré pour que, lorsqu'un défaut électrique correspondant aux critères du filtre primaire 222 et du filtre secondaire 322 survient :
- le boitier de départ 300 détecte le défaut électrique au moyen des moyens de détection secondaire 312, puis le microcontrôleur 320 du boitier de départ commande le passage en position ouverte des moyens de coupure électromécaniques 310,
- tandis que le boitier principal 200 détecte le même défaut électrique au moyen des moyens de détection principaux 212, puis l'unité de contrôle 214 du boitier principal 200 commande le passage des moyens de coupure 210 en configuration de coupure.

Compte tenu de la proximité du boitier principal 300 avec le boitier de départ 300, on considère que la détection du même défaut électrique par le boitier principal 200 et par le boitier de départ 300 est simultanée.

L'ensemble de distribution 100 est configuré pour que le boitier principal 200 passe dans la configuration de coupure avant que le premier boitier ne passe de la configuration fermée à la configuration ouverte. Autrement dit, le délai de coupure ΔC est inférieur au délai d'ouverture ΔO, de sorte que lorsque les contacts séparables des moyens de coupure électromécaniques 310 commencent à se déplacer de la position fermée vers la position ouverte, alors aucun courant ne circule dans le bus de puissance 114. Les contacts séparables des moyens de coupure électromécaniques 310 s'ouvrent sans qu'il y ait génération d'arc électrique, ce qui permet de réduire l'usure des contacts séparables et contribue à la durabilité des boitiers de départ 300.

Une fois que le boitier de départ 300 est en configuration ouverte, le boitier principal 200 est configuré pour passer de la configuration de coupure à la configuration passante au bout d'un temps d'attente ΔW prédéterminé, le temps d'attente ΔW étant supérieur au délai d'ouverture.

On considère le cas où l'ensemble de distribution comprend deux boitiers de départ 300 ou plus, les deux boitiers de départ 300 incluant un premier boitier et un deuxième boitier, qui sont conjointement connectées aux barres conductrices 122. Autrement dit, les deux boitiers de départ 300 sont montés sur le même dispositif de distribution 110. En fonctionnement normal de l'ensemble de distribution 100, le boitier principal 200 est initialement dans la configuration passante, tandis que le premier boitier 300 et le deuxième boitier 300 sont chacun initialement dans la configuration fermée. On suppose que le premier boitier 300 et le deuxième boitier 300 sont chacun connectés à une charge électrique respective.

Lorsqu'un défaut électrique survient aux bornes de départ 300 du premier boitier 300, par exemple suite à une défaillance de la charge électrique connectée au premier boitier 300, le premier boitier 300 de départ détecte ce défaut électrique au moyen des moyens de détection secondaire 312 du premier boitier 300 et, simultanément, le boitier principal 200 détecte aussi ce défaut électrique au moyen des moyens de détection principaux 212. Comme précédemment, le boitier principal 200 passe dans la configuration de coupure avant que le premier boitier 300 ne passe de la configuration fermée à la configuration ouverte, tandis que le deuxième boitier 300 reste dans la configuration fermée.

Ensuite, le boitier principal 200 passe de la configuration de coupure à la configuration passante au bout du temps d'attente ΔW, le deuxième boitier 300 restant dans la configuration fermée. Le temps d'attente ΔW est suffisamment court pour que la rupture d'alimentation subie par la charge électrique associée au deuxième boitier 300 n'ait pas d'impact négatif. En pratique, le temps d'attente ΔW est inférieur à 20 ms, de préférence inférieur à 15 ms, de préférence encore inférieur à 10 ms.

Dans l'exemple illustré, chaque boitier de départ 300 comprend un microcontrôleur 320, qui analyse les mesures des moyens de détection secondaires 312 et détermine la présence d'un défaut électrique, en particulier un défaut différentiel. Cela nécessite que le microcontrôleur soit alimenté par une source d'énergie électrique, ici par l'intermédiaire du bus de transfert 150. Les principes de l'invention sont transposables au cas où les boitiers de départ 300 ne comprennent pas de microcontrôleur, l'actionneur 324 étant par exemple directement alimenté par le différentiel de courant mesuré par les moyens de détection secondaires 312.

Les modes de réalisation et les variantes mentionnées ci-dessus peuvent être combinés entre eux pour générer de nouveaux modes de réalisation de l'invention.

## Revendications

1. Ensemble de distribution (100), configuré pour distribuer de l'énergie électrique provenant d'une source de puissance à au moins une charge électrique, la source de puissance comprenant un neutre et au moins une phase, dans lequel :
- l'ensemble de distribution (100) comprend un bus de puissance (124), qui comprend plusieurs barres conductrices (122) :
• qui incluent au moins une barre de phase et éventuellement une barre de neutre, la barre de neutre éventuelle étant associée au neutre de la source de puissance, chaque barre de phase étant respectivement associée à une phase de la source de puissance,
• qui s'étendent parallèlement entre elles selon un axe principal (A110) de l'ensemble de distribution (100) et qui sont alignées selon un axe de hauteur (H110) qui est orthogonal à l'axe principal (A110),
- les barres conductrices (122) comprennent chacune :
• une portion d'alimentation (126), qui est configurée pour être connectée à une borne de sortie (204) d'un boitier principal (200) dans une configuration montée du boitier principal (200),
• une portion de connexion (128), qui s'étend d'un même côté de la portion d'alimentation (126), les portions de connexion (128) étant géométriquement situées d'un côté avant d'un plan de connexion (P124) parallèle à l'axe principal (A110) et à l'axe de hauteur (H110) et définissant ensemble une zone de connexion du bus de puissance (124), la zone de connexion étant configurée pour recevoir au moins un boitier de départ (300) de sorte que le boitier de départ (300) est relié au bus de puissance (124), chaque boitier de départ (300) étant propre à être connecté à une charge électrique respective, de manière à alimenter la charge électrique en puissance électrique,
- l'ensemble de distribution (100) comprend un dispositif de refroidissement (400), qui inclut :
• une plaque de contact (410), qui présente une face de contact (412) qui s'étend parallèlement au plan de connexion (P124), la face de contact (412) étant configurée pour coopérer, notamment par complémentarité de formes, avec une face arrière (231) du boitier principal (200) en configuration montée, de manière à favoriser le transfert thermique entre la plaque de contact (410) et le boitier principal (200),
• un radiateur (420) qui s'étend le long de la zone de connexion, d'un côté arrière du plan de connexion (P124),
• au moins un caloduc (430), qui relie la plaque de contact (410) au radiateur (420) et qui est configuré pour transférer au radiateur (420) une partie de la chaleur captée par la plaque de contact (410), le radiateur (420) étant configuré pour dissiper dans l'air la chaleur transférée par chaque caloduc (430).

2. Ensemble de distribution (100) selon la revendication 1, dans lequel :
- l'ensemble de distribution (100) inclut le boitier principal (200), le boitier principal (200) étant monté sur le reste de l'ensemble de distribution (100) et comprenant :
• des bornes d'entrée (202), qui sont configurées pour être reliées à chaque phase et au neutre éventuel de la source de puissance,
• des bornes de sortie (204), qui sont reliées aux barres conductrices (122), chaque borne de sortie (204) étant associée à une barre conductrice (122) respective et à une borne d'entrée (202) respective,
• la face arrière (231), qui coopère, notamment par complémentarité de formes, avec la face de contact (412).

3. Ensemble de distribution (100) selon la revendication 2, dans lequel :
- le boitier principal (200) comprend des moyens de coupure, notamment statiques, qui sont commutables entre une configuration passante, dans laquelle chaque borne d'entrée est électriquement reliée à la borne de sortie (204) associée, le boitier principal (200) étant dans une configuration passante, et une configuration de coupure, dans laquelle le passage d'un courant électrique entre la borne d'entrée et la borne de sortie (204) associée est empêché, le boitier principal (200) étant dans une configuration de coupure,
- le boitier principal (200) comprend une paroi arrière, qui est réalisée en un matériau thermiquement conducteur et électriquement isolant et qui comporte la face arrière (231), la paroi arrière étant intercalée entre les moyens de coupure et la plaque de contact (410), de manière qu'une partie de la chaleur générée par les moyens de coupure en fonctionnement est transférée à la plaque de contact (410) au travers de la paroi arrière.

4. Ensemble de distribution (100) selon l'une quelconque des revendications 1 à 3, dans lequel le au moins un caloduc (430) est un caloduc (430) diphasique.

5. Ensemble de distribution (100) selon la revendication 4, dans lequel :
- le au moins un caloduc (430) est un caloduc diphasique de type capillaire,
- lorsque l'ensemble de distribution (100) est dans une configuration normale de fonctionnement, l'axe principal (A110) est horizontal.

6. Ensemble de distribution (100) selon l'une quelconque des revendications 1 à 5, dans lequel :
- l'ensemble de distribution (100) comprend une paroi isolante (118), qui est réalisée en un matériau électriquement isolant et qui est intercalée entre le bus de puissance (124) et le radiateur (420), la paroi isolante (118) étant ouverte vers l'avant de la plaque de contact (410),
- les bornes de sortie (204) du boitier principal (200) sont des pinces de raccordement, qui sont chacune prévues pour la connexion à une barre conductrice (122) respective, selon un mouvement de connexion orienté vers l'arrière de l'ensemble de distribution (100), de sorte que, au cours du mouvement de connexion des bornes de sortie (204) aux barres conductrices (122), la face arrière (231) du boitier principal (200) vient en appui contre la face de contact (412).

7. Ensemble de distribution (100) selon l'une quelconque des revendications 1 à 6, dans lequel :
- l'ensemble de distribution (100) comprend une portion arrière (112), qui ménage une cavité (V110) de réception du dispositif de refroidissement (400), la portion arrière (112) étant réalisée en un matériau électriquement isolant,
- la portion arrière (112) est ajourée, de manière à favoriser le refroidissement, par convection, du dispositif de refroidissement (400).

8. Tableau électrique (10), comprenant :
- un coffre (12), délimitant une enceinte (V12) et présentant un fond (14),
- l'ensemble de distribution (100) selon l'une quelconque des revendications 1 à 7,
dans lequel l'ensemble de distribution (100) est fixé sur le fond (14) du boitier, l'axe principal (A110) étant parallèle au fond du coffre, de préférence horizontal.
